Europäisches Patentamt

European Patent Office

Office européen des brevets

(11) Publication number: **0 308 127**
**A2**

# EUROPEAN PATENT APPLICATION

(21) Application number: 88308259.6

(22) Date of filing: 07.09.88

(51) Int. Cl.⁴: **H01L 31/10 , H01L 31/02 , H01L 27/14**

(30) Priority: 11.09.87 JP 228179/87

(43) Date of publication of application:
**22.03.89 Bulletin 89/12**

(84) Designated Contracting States:
**DE FR GB**

(71) Applicant: **SEIKO INSTRUMENTS INC.**
**31-1, Kameido 6-chome Koto-ku**
**Tokyo 136(JP)**

(72) Inventor: **Kawahara, Yukito**
**Seiko Instruments Inc. 31-1 Kameido**
**6-chome**
**Koto-ku Tokyo(JP)**
Inventor: **Machida, Satoshi**
**Seiko Instruments Inc. 31-1 Kameido**
**6-chome**
**Koto-ku Tokyo(JP)**
Inventor: **Mukainakano, Hiroshi**
**Seiko Instruments Inc. 31-1 Kameido**
**6-chome**
**Koto-ku Tokyo(JP)**

(74) Representative: **Caro, William Egerton et al**
**J. MILLER & CO. Lincoln House 296-302 High**
**Holborn**
**London WC1V 7JH(GB)**

(54) Semi-conductor photo-detecting device.

(57) A semi-conductor photo-detecting device comprises a semi-conductor substrate (3) of one electro-conductive type, a doped region of opposite electro-conductive type formed within the semi-conductor substrate (3) to form a pn junction between the doped region and the substrate to constitute a photo-detecting element 7 and a passivation film (2) formed on the photo-detecting element (7). The passivation film (2) has a non-constant thickness so that intensity variation of light irradiated onto the photo-detecting element is reduced or eliminated.

FIG 1A

FIG 1B

EP 0 308 127 A2

## SEMI-CONDUCTOR PHOTO-DETECTING DEVICE

This invention relates to semi-conductor photo-detecting devices and to image sensors, for example, for receiving reflected light from printed matter which is irradiated by a light source and for converting the reflected light into an electric signal. More specifically, although not so restricted, the present invention concerns a semi-conductor photo-detecting device of the contact type having a light receiving portion positionable in contact with printed matter directly to read the same.

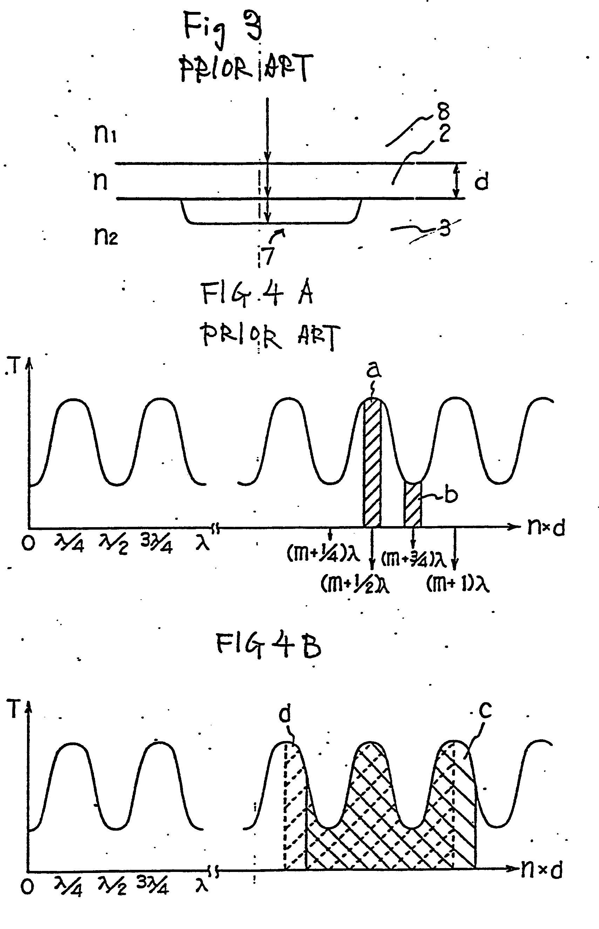

Figure 2 shows a conventional semi-conductor photo-detecting device comprising a photo-detecting element 7 and a driving element 9 for selecting the corresponding photo-detecting element 7 and amplifying an electric signal produced in the photo-detecting element 7. The photo-detecting element 7 and the driving element 9 are formed on a common semi-conductor substrate, and covered with an outer passivation film 2 to protect the elements 7, 9 from the environment. The elements 7, 9 are covered with an inner passivation film 4 and connected to each other by a lead 1 passing through a contact hole 5.

Figure 3 is a sectional view of the photo-detecting element 7 formed in a semi-conductor substrate 3 and covered with the passivation film 2. The light transmittance T of the photo-detecting element 7 for normal incident light travelling through air 8 is determined by the following relation:

$$T= \frac{4 n_2\, n^2\, n_1}{n^2 (n_1 + n_2)^2 - (n^2 - n_1^2)(n_2^2 - n^2) \sin(\delta/2)} \quad -- (1)$$

where $\delta = \dfrac{2\pi nd}{\lambda}$   (2)

$n_1$ : refractive index of air

n : refractive index of passivation film

$n_2$ : refractive index of semiconductor substrate

d : thickness of passivation film

$\lambda$ : wavelength of incident light.

The light transmittance T has maximum and minimum values when $\delta = (2m + 1)\pi$ where m is an integer. Figure 4A shows the light transmittance T as a function of n.d. Namely, the intensity of light irradiated onto the photo-detecting element 7 is determined by the thickness d of the passivation film 2, and therefore, the intensity of the electric signal produced in the individual photo-detecting element 7 is not constant. As shown in Figure 4A, when the thickness of the passivation film 2 is different between two individual photo-detecting elements formed on the common semi-conductor substrate 3, the light transmittance T or the intensity of light irradiated onto the two photo-detecting elements is not equal as indicated by hatched portions a and b.

Stated otherwise, mono-chromatic incident light is multi-reflected between the opposed major faces of the passivation film and the intensity of the mono-chromatic light received on the individual photo-detecting element is varied due to the difference of the thickness of the passivation film. In this conventional semi-conductor photo-detecting device, it is very difficult to form a passivation film of constant thickness over the entire surface of the semi-conductor substrate.

The present invention seeks to provide a semi-conductor photo-detecting device where intensity variation of light irradiated onto individual photo-detecting elements is eliminated.

According to one aspect of the present invention, there is provided a semi-conductor photo-detecting device comprising: a semi-conductor substrate of one electro-conductive type; a doped region of opposite electro-conductive type formed within the semi-conductor substrate to form a pn junction between the doped region and the substrate to constitute a photo-detecting element; and a passivation film formed on the photo-detecting element, characterised in that the passivation film has a non-constant thickness.

According to another aspect of the present invention, there is provided a semi-conductor photo-detecting device comprising: a semi-conductor substrate; a photo-detecting element formed on the substrate for effecting photo-electric conversion; an inner passivation film formed on the photo-detecting element; and an outer transparent passivation film formed on the inner passivation film entirely to cover the photo-detecting element characterised in that the photo-detecting element has a plurality of openings therein.

According to a further aspect of the present invention, there is provided a semi-conductor photo-detecting device characterised by comprising: a semi- conductor substrate; a plurality of photo-detecting elements arranged linearly on the semi-conductor substrate to effect photo-electric conversion, each photo-detecting element having an uneven surface; a plurality of driving elements arranged linearly on the semi-conductor substrate in parallel to the plurality of photo-detecting elements, each driving element being composed of a MOS circuit and corresponding to each photo-detecting element sequentially to read an output signal produced by the corresponding photo-detecting element.

Preferably, the uneven surface is formed during fabrication of the driving elements.

In a yet further aspect of the present invention there is provided a semi-conductor photo-detecting device comprising: a photo-detecting element for effecting photo-electric conversion; and at least one insulating passivation film disposed on the photo-detecting element, characterised by a plurality of LOCOS oxide regions interposed between the insulating passivation film and the photo-detecting element to cause the insulating passivation film to be uneven or have a non-constant thickness.

In one embodiment, the photo-detecting element comprises a base region composed of a first region formed thereon with the LOCOS oxide regions and having a relatively great junction depth and a second region formed adjacent to the first region and having a relatively small junction depth, and an emitter region formed within the second region.

The invention is illustrated, merely by way of example, in the accompanying drawings, in which:-

Figure 1A is a sectional view of one embodiment of a semi-conductor photo-detecting device according to the present invention;

Figure 1B is a plan view of the semi-conductor photo-detecting device of Figure 1A;

Figure 2 is a sectional view of a conventional semi-conductor photo-detecting device;

Figure 3 is a sectional view of a photo-detecting element of the semi-conductor photo-detecting device of Figure 2;

Figure 4A is a diagram showing light intensity received by the photo-detecting element of Figure 3;

Figure 4B is a diagram showing the light intensity received by a photo-detecting element of a semi-conductor photo-detecting device according to the present invention;

Figures 5A and 5B are a sectional view and a plan view of another embodiment of a semi-conductor photo-detecting device according to the present invention;

Figure 6 is a circuit diagram of the semi-conductor photo-detecting device of Figures 5A and 5B;

Figure 7 is a sectional view of a further embodiment of a semi-conductor photo-detecting device according to the present invention;

Figures 8A, 8B, 8C and 8D are diagrams explaining a method of making the semi-conductor photo-detecting device shown in Figure 7;

Figure 9 is a sectional view of a still further embodiment of a semi-conductor photo-detecting device according to the present invention; and

Figure 10 is a sectional view of a conventional photo-detecting element.

Referring first to Figure 1A there is shown a sectional view of one embodiment of a semi-conductor photo-detecting device according to the present invention. A photo-detecting element 7 for photo- electric conversion and a driving element 9 composed of semi-conductor integrated circuits formed on and in a semi-conductor substrate 3 of one conductivity type. The photo-detecting element 7 comprises a doped region formed in and of opposed conductivity type to the semi-conductor substrate 3 to form a pn junction between the doped region and the semi-conductor substrate. The photo-detecting element 7 and the driving element 9 are covered with an inner insulating passivation film 4. The passivation film 4 is formed with contact holes 6 on the surface of the photo-detecting element 7. The inner passivation film 4 is covered with an outer passivation film 2. The photo-detecting element 7 is connected to the driving element 9 by a lead 1 and contact holes 5.

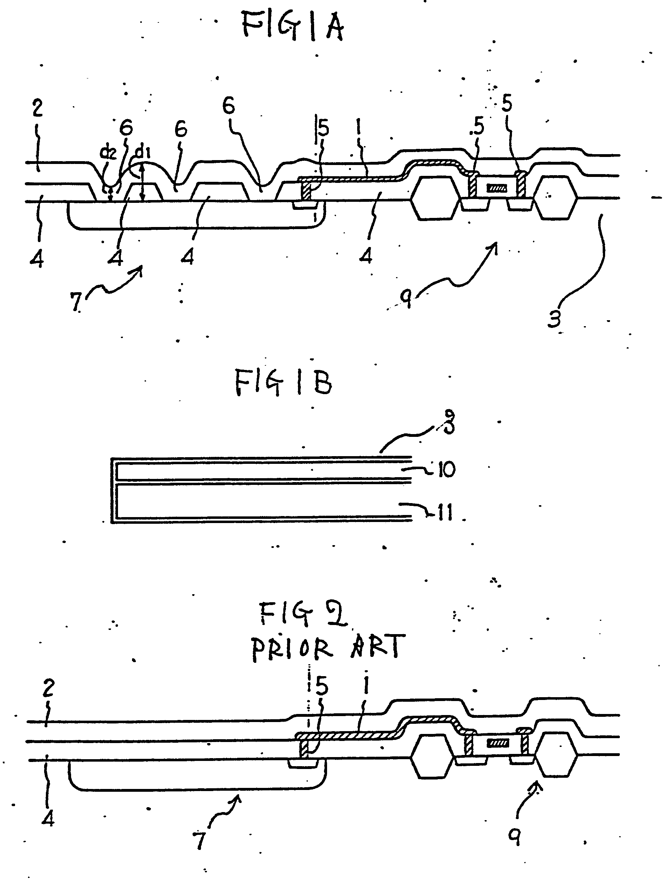

Figure 1B is a plan view of the semi-conductor photo-detecting device shown in Figure 1A. A photo-detecting portion 10 is linearly arranged in the lengthwise direction of the semi-conductor substrate 3 and a driving portion 11 for processing electric signals produced in the photo-detecting portion 10 is arranged in parallel therewith. The photo-detecting portion 10 is comprised of a plurality of photo-detecting elements 7, and the driving portion 11 is composed of a plurality of driving elements 9 corresponding to the respective photo-detecting elements 7.

The semi-conductor photo-detecting device is produced as follows. The photo-detecting portion 10 and the driving portion 11 are formed on the semi-conductor substrate 3 by means of semi-conductor fabrication technology, such as thermal oxidation, photo-lithography, ion doping and thermal diffusion. Thereafter, the inner passivation film 4 made of, for example, phospho-silicate glass (PSG) is formed on the substrate 3. The passivation film 4 is etched to form therein the contact holes 5 and provided thereon with an electro-conductive thin film made of, for example, aluminium. The aluminium thin film is etched by means of photo-lithography to form the leads 1. Then, the inner passivation film 4 is selectively etched over the individual photo-detecting elements 7 to form therethrough the contact holes 6. In the last step of the fabrication process, the photo-detecting elements 7 and the driving elements 9 are covered with the outer transparent passivation film 2 made of $SiO_2$, SiN or PSG to protect the elements 7, 9 against the environment. At this time, if the outer and inner passivation films 2,4 are made of materials having the same refractive index, the before mentioned relation (1) can be applied to calculation of the light transmittance of incident light.

The above fabrication process causes the outer and inner passivation films 2, 4 to be uneven, i.e. of non-constant thickness. The present invention is not limited to semi-conductor photo-detecting devices of the type comprised of a photo-detecting portion 10 and a driving portion 11, but also can be applied to those comprised solely of a photo-detecting portion. The photo-detecting elements can be photo-diodes, photo-transisters, etc.

According to the present invention, the uneven thickness of the passivation films can effectively avoid variation of transmittance of the incident light to maintain the level of the electric signal from the photo-detecting portion constant.

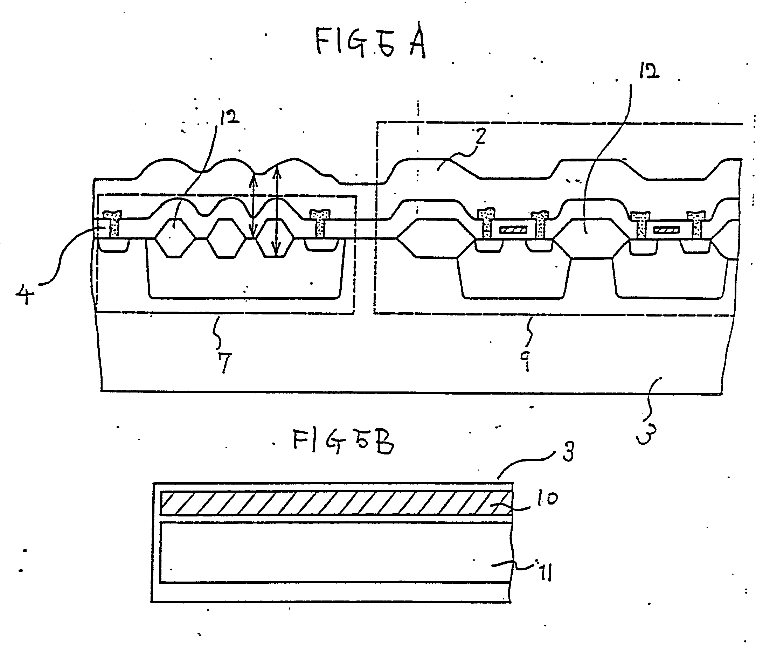

Figures 5A and 5B are sectional and plan views of another embodiment of a semi-conductor photo-detecting device according to the present invention. In this embodiment, a driving element 9 is formed of complemen tary metal oxide semi-conductor (CMOS) such that a photo-detecting element 7 can be formed on a common semi-conductor substrate 3 during the fabrication process of wells of the CMOS. The photo-detecting element 7 comprises a doped region formed in and of opposite conductivity type to the semi-conductor substrate 3 to form a pn junction between the doped region and the semi-conductor substrate. Further, an uneven film of non-constant thickness over the individual photo-detecting element 7 is formed by means of a local-oxidation-of-silicon (LOCOS) process which cannot alter the CMOS fabrication process.

As shown in Figure 5B, a photo-detecting portion 10 is formed linearly in the lengthwise direction of the semi-conductor substrate of one electro-conductive type, and a driving portion 11 for processing electric signals produced in the photo-detecting portion 10 is arranged in parallel therewith. Figure 5A is a sectional view taken in the width-wise direction of the semi-conductor substrate 3 in which one photo-detecting element 7 and corresponding driving element 9 are illustrated.

This photo-detecting semi-conductor device is fabricated by CMOS technology. The driving portion 11 is formed on the semi-conductor substrate 3 which is a single crystal of one electro-conductive type by means of semi-conductor fabrication technology, such as thermal oxidation, photo-lithography, ion doping and thermal diffusion. At this time, the photo-detecting portion 10 can be formed during the formation of wells of the CMOS. Further, LOCOS regions 12 which are formed by a LOCOS process are provided in the driving element 9 to separate various regions thereof. At the same time, other LOCOS regions 12 are provided on the photo-detecting element 7 to form the required unevenness thereon. In the final step, the photo-detecting element 7 and driving element 9 are covered with inner and outer transparent passivation films 4, 2 made of, for example, $SiO_2$, SiN or PSG to protect the elements 7, 9 against the environment. Such a process applied to CMOS produces an uneven film composed of the LOCOS regions 12 and the inner and outer passivation films 4, 2 formed on the photo-detecting element 7.

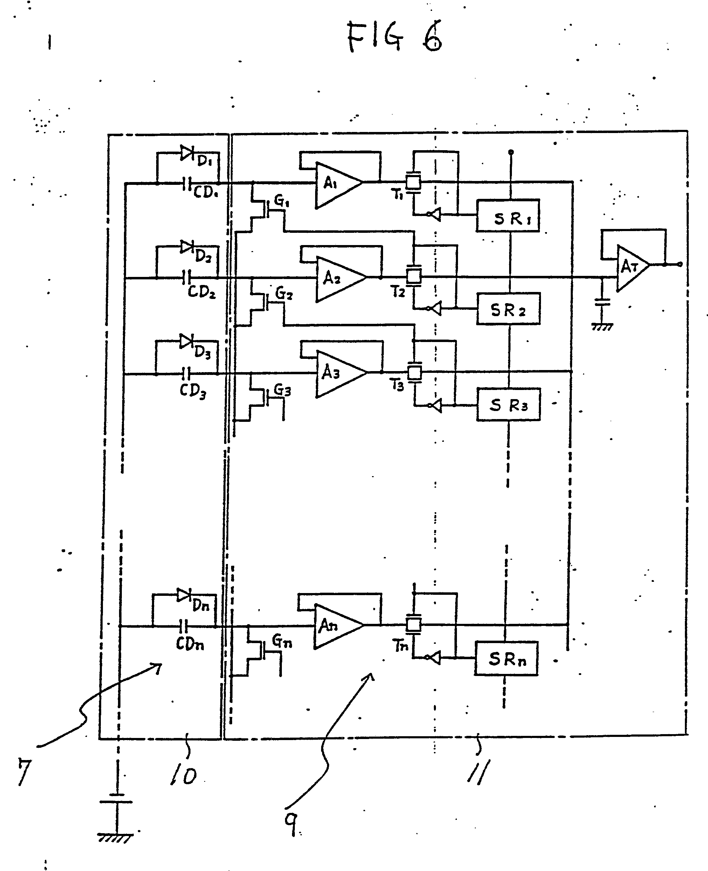

Figure 6 is an equivalent circuit diagram of the semi-conductor photo-detecting device of Figures 5A and 5B. The individual photo-detecting elements 7 are represented by a photo-diode Dn and a capacitor CDn. The individual driving elements 9 are comprised of a CMOS transistor Gn for discharging the capacitor CDn and an amplifier An connected to the corresponding individual photo-detecting element 7 for amplifying the electric signal therefrom. The amplified signal is outputted through a transmission gate Tn when the gate Tn is open in response to a control signal from a shift register SRn. The transistor Gn, amplifier An and transmission gate Tn are formed by CMOS fabrication. The photo-diode Dn may be replaced by a photo-transistor.

According to the present invention, the photo-detecting element is covered with the transparent uneven film effective to maintain the intensity of incident light irradiated onto the photo-detecting element even if the mean thickness of the passivation films are not uniform over the entire surface of the semi-conductor substrate. Further, the CMOS process can be applied to form the photo-detecting elements and driving elements on the common substrate at the same time.

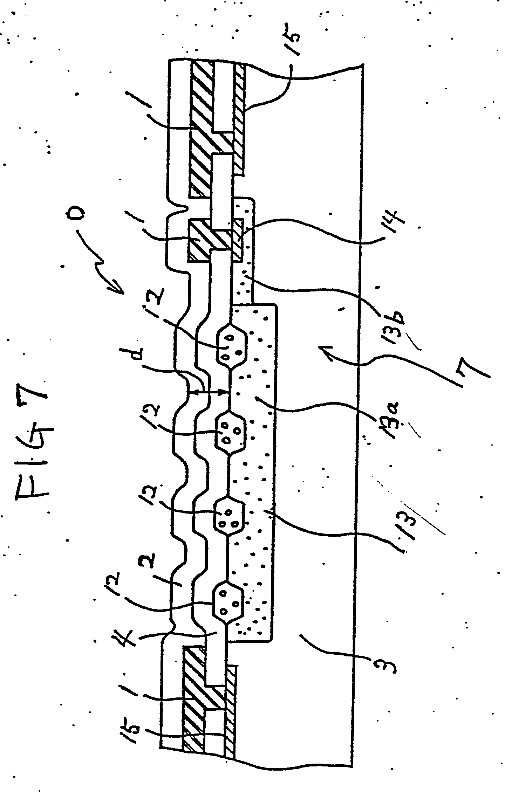

Figure 7 shows a further embodiment of a semi-conductor photo-detecting device or image sensor O according to the present invention. The image sensor O is comprised of a plurality of photo-detecting elements 7 formed on a small $n^-$ type semi-conductor substrate 3. In Figure 7, only one photo-detecting element 7 is illustrated. A p-well 13 is formed on the substrate 3 to operate as a base region. The p-well 13 is selectively diffused within the $n^-$ type substrate 3 and comprised of a first deep diffusion region 13a operating as a light receiving portion, and a second shallow diffusion region 13b operating as a base region of a transistor with a high amplification factor. A plurality of LOCOS oxide film regions 12 are formed on the

4

surface of the first region 13a. The LOCOS oxide regions 12 are dots and arranged in rows and columns at a given interval.

In Figure 7, an $n^+$ type emitter region 14 is formed within the second region 13b and an $n^+$ type collector region 15 is formed on the $n^-$ type substrate 3.

The emitter region, base region and collector region are covered with inner and outer passivation films 4, 2 made of, for example, $SiO_2$ and SiN. Leads 1 made of aluminium are formed on the inner passivation film 4 and connected between the emitter region 14 and the collector region 15.

The surface of the first region 13a is uneven due to the LOCOS oxide regions 12, so that the inner and outer passivation films 4, 2 formed on the LOCOS oxide regions 12 are also uneven along the LOCOS region 12. Consequently, the distance d between the surface of the first region 13a and the outer surface of the outer passivation film 2 is varied to reduce the effect of the multi-reflection of incident light within the outer and inner passivation films 4, 2 and the LOCOS oxide regions 12. Therefore, the output fluctuation of the image sensor O between the leads 1 of the emitter and collector regions 14, 15 is reduced thereby to offer an image sensor having a constant output characteristic.

Moreover, the LOCOS oxide regions 12 are formed on the first region 13a to make unevenness on the first region 13a. This formation of the LOCOS oxide regions can be carried out during the step of separating logic elements. Therefore, in most cases, an additional separate step to form the LOCOS regions is not needed, thereby reducing production costs.

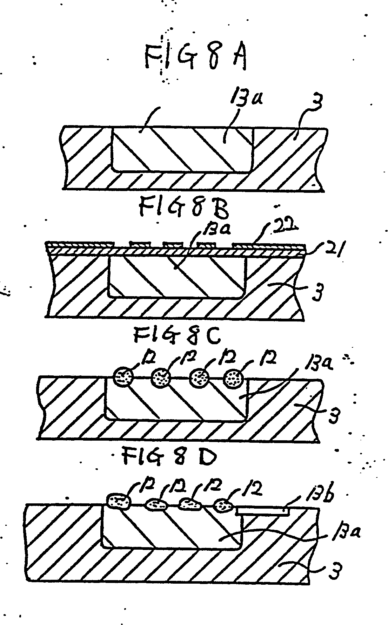

Figures 8A to 8D illustrate steps of forming the LOCOS oxide regions 12 of the semi-conductor photo-detecting device of Figure 7. Firstly, the first region 13a of the p-well 13 is formed within the $n^-$ type substrate 3 by patterning (Figure 8A). Then a silicon oxide film 21 and a silicon nitride (SiN) film 22 are formed on the $n^-$ type substrate 3 and only the silicon nitride film 22 is patterned to form windows for the formation of the LOCOS oxide regions (Figure 8B). Thereafter, the substrate 3 is placed within an oxygen gas atmosphere such that oxygen is doped locally into the p-well 13 through the windows to form the LOCOS oxide regions 12 on the first region 13a, and then the silicon nitride film 22 and silicon oxide film 21 are removed (Figure 8C). Lastly, the second region 13b is formed adjacent to the first region 13a by a shallow diffusion process (Figure 8D). The subsequent steps are omitted because they are similar to the conventional steps.

As shown in Figure 8D, the shallow second region 13b is formed adjacent to the deep first region 13a and the emitter region 14 is formed within this second region 13b so that the amplification factor $h_{fe}$ of the photo-transistor is relatively large. Therefore, it is possible to avoid reduction of the image sensor output level even when the diffusion or junction depth of the first region 13a is made great due to the addition of the LOCOS oxide regions 12.

Further, in the above described embodiment, the LOCOS oxide region 12 has a dot shape. However, the present invention is not limited to the dot shape, but a strip shape, or other shapes can be adopted. It will be appreciated from the above description that any shape can be used to vary the distance d between the surface of the base region which receives the incident light and the outer surface of the passivation film 2.

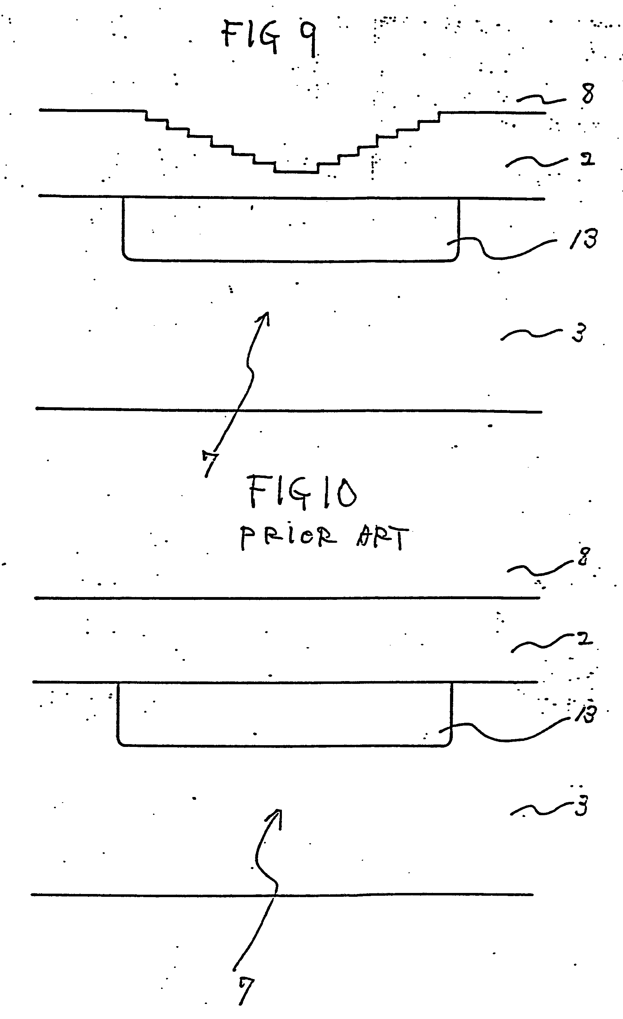

Figure 9 shows a still further embodiment of a semi-conductor photo-detecting device according to the present invention. A doped region 13 of one electro-conductive type is formed within a semi-conductor substrate 3 of the opposite electro-conductive type to form, along the boundary between the region 13 and substrate 3, a pn junction to constitute a photo-detecting element 7. The doped region 13 is covered with a passivation film 2 having a step-wise change of thickness. The number of steps formed in the passivation film 2 can be increased to improve the stability of the electric signal produced in the photo-detecting element 7. The passivation film 2 having a different thickness over the doped region 13 can effectively maintain the intensity of ligh irradiated onto the pn junction at a constant level even if the mean thickness of the passivation film 2 is changed as compared to a passivation film 2 of uniform thickness as shown in Figure 10.

According to the present invention, therefore, the individual photo-detecting element is covered with a film having an uneven surface to avoid multi-reflection of mono-chromatic incident light. As shown in Figure 4B, when the uneven film has a different mean thickness between two individual photo-detecting elements, the intensity of light irradiated onto the two individual elements through the uneven film is the same as indicated by hatched portions c and d. The uneven film transmits the same intensity of incident light even if the mean thickness of the uneven film is not constant over the entire surface of the semi-conductor substrate. As shown in Figure 1A, the passivation films 2, 4 over one photo-detecting element 7 have a maximum thickness $d_1$ and a minimum thickness $d_2$. The intensity of light received by the element 7 is a total of light components travelling through the thick and thin portions of the passivation films 2, 4 without multi-reflection. Therefore, the intensity of light is constant even if the mean thickness of the passivation films is varied.

## Claims

1. A semi-conductor photo-detecting device comprising: a semi-conductor substrate (3) of one electro-conductive type; a doped region of opposite electro-conductive type formed within the semi-conductor substrate (3) to form a pn junction between the doped region and the substrate to constitute a photo-detecting element (7); and a passivation film (2) formed on the photo-detecting element (7), characterised in that the passivation film (2) has a non-constant thickness.

2. A semi-conductor photo-detecting device comprising: a semi-conductor substrate (3); a photo-detecting element (7) formed on the substrate for effecting photo-electric conversion; an inner passivation film (4) formed on the photo-detecting element; and an outer transparent passivation film (2) formed on the inner passivation film (4) entirely to cover the photo-detecting element characterised in that the photo-detecting element (7) has a plurality of openings (6) therein.

3. A semi-conductor photo-detecting device characterised by comprising: a semi-conductor substrate (3); a plurality of photo-detecting elements (7) arranged linearly on the semi-conductor substrate to effect photo-electric conversion, each photo-detecting element having an uneven surface; a plurality of driving elements (9) arranged linearly on the semi-conductor substrate in parallel to the plurality of photo-detecting elements (7), each driving element being composed of a MOS circuit and corresponding to each photo-detecting element sequentially to read an output signal produced by the corresponding photo-detecting element.

4. A semi-conductor photo-detecting device as claimed in claim 3, characterised in that the uneven surface is formed during fabrication of the driving elements (9).

5. A semi-conductor photo-detecting device comprising: a photo-detecting element (7) for effecting photo-electric conversion; and at least one insulating passivation film (4) disposed on the photo-detecting element, characterised by a plurality of LOCOS oxide regions (12) interposed between the insulating passivation film and the photo-detecting element to cause the insulating passivation film to be uneven or have a non-constant thickness.

6. A semi-conductor photo-detecting device as claimed in claim 5, characterised in that the photo-detecting element (7) comprises a base region composed of a first region (13a) formed thereon with the LOCOS oxide regions (12) and having a relatively great junction depth and a second region (13b) formed adjacent to the first region and having a relatively small junction depth, and an emitter region (14) formed within the second region (13b).

# FIG 1 A

# FIG 1 B

# FIG 2
# PRIOR ART

EP 0 308 127 A2

# Fig 3
## PRIOR ART

# FIG.4 A
## PRIOR ART

# FIG 4 B

# FIG 5 A

# FIG 5B

# FIG 6

# FIG 7

EP 0 308 127 A2

FIG 8 A

FIG 8 B

FIG 8 C

FIG 8 D

FIG 9

8

2

13

3

7

FIG 10
PRIOR ART

8

2

13

3

7